(19) Europäisches Patentamt
European Patent Office
Office européen des brevets

(11) **EP 4 678 601 A1**

(12) **EUROPEAN PATENT APPLICATION**

(43) Date of publication:
**14.01.2026  Bulletin 2026/03**

(21) Application number: **25181242.6**

(22) Date of filing: **06.06.2025**

(51) International Patent Classification (IPC):
*C01G 53/42* (2025.01)      *C01G 53/504* (2025.01)
*C01G 53/506* (2025.01)    *H01M 4/00* (2006.01)

(52) Cooperative Patent Classification (CPC):
**C01G 53/504; C01G 53/42; C01G 53/506;
H01M 4/366; H01M 4/505; H01M 4/525;
H01M 4/62;** C01P 2002/52; C01P 2004/61;
C01P 2004/80; C01P 2006/12; H01M 2004/028;
Y02E 60/10

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **11.06.2024  CN 202410741623**

(71) Applicants:
• **Guizhou Zhenhua E-CHEM Inc.
Guiyang City, Guizhou Province 550014 (CN)**
• **Guizhou Zhenhua E_CHEM Co., Ltd.
Guiyang City, Guizhou Province 550014 (CN)**
• **Guizhou Zhenhua Yilong E-CHEM Co., Ltd
Southwest Guizhou, Autonomous Prefecture
552401 (CN)**

(72) Inventors:
• **HUANG, Jin
Guiyang City, Guizhou Province, 550014 (CN)**
• **WANG, Lijuan
Guiyang City, Guizhou Province, 550014 (CN)**
• **YU, Ye
Giyang City, Guizhou Province, 550014 (CN)**
• **LI, Lu
Guiyang City, Guizhou Province, 550014 (CN)**
• **ZHOU, Chaoyi
Guiyang City, Guizhou Province, 550014 (CN)**

(74) Representative: **Bardehle Pagenberg
Partnerschaft mbB
Patentanwälte Rechtsanwälte
Prinzregentenplatz 7
81675 München (DE)**

(54) **SINGLE-CRYSTAL CATHODE MATERIAL AND PREPARING METHOD THEREOF**

(57)      The present application provides a single-crystal cathode material and preparing method thereof. The method involves mixing and ball milling a lithium source with a nickel-cobalt-manganese precursor and then performing a first sintering treatment to obtain the first main material, wherein sintering temperature is 650 to 950°C and sintering time is 15 to 30 hours. The first main material is then mixed and ball-milled with source A and performing a second sintering treatment to prepare the single-crystal cathode material, wherein sintering temperature is 650~ 950°C and sintering time is 5~15 hours. The present application uses a polycrystalline precursor to directly prepare a single-crystal cathode material without jet milling, making the process simple and cost-effective, and greatly enhancing the compatibility of the process.

Fig 3

EP 4 678 601 A1

# EP 4 678 601 A1

## Description

## Technical Field

The present disclosure relates to single-crystal cathode material and preparing method thereof, belonging to field of lithium-ion battery technology.

## Background

With the vigorous development of the global electric vehicle and battery market, lithium-ion batteries have become main battery technology route in the field of new energy vehicles and energy storage, and the business of lithium-ion battery cathode materials is an important part of the lithium battery industry chain. In the early days, the lithium battery cathode material was mainly polycrystalline. With the rapid development of the new energy industry, fast charging and high voltage have become market demands, and single-crystal cathode materials have become the main technical route.

Single-crystal cathode materials have no grain boundaries inside, which makes them less likely to grain boundary cracking and secondary particle breakage during the charging and discharging process, thereby improving the cycle stability of the battery. Since single-crystal materials reduce grain boundaries, they reduce side reactions with the electrolyte, which helps to improve the safety and life span of the battery. Moreover, single-crystal materials can increase the packing density, thereby increasing the energy density of the battery.

In the prior art, amorphous precursor sintering methods and jet milling methods are generally used to prepare single-crystal cathode materials. Among them, the amorphous precursor sintering methods have high requirements for the precursor, which needs to control the crystal structure of the precursor through co-precipitation methods. It is not only a complex method with high costs, but also causes uneven ion precipitation during the precipitation process, leading to lower battery performance. The jet milling method is to grind the sintered cathode material by gas flow collision to obtain single-crystal cathode materials. However, the jet milling method produces fine powders, and it is necessary to separate the fine powders with a cyclone, which increases the production cost.

## Summary

In view of the shortcomings in the existing technology, this invention proposes a single-crystal cathode material and preparing method thereof, which uses a polycrystalline precursor to prepare single-crystal cathode material without the need for the jet milling, greatly improving the compatibility of the process.

The technical solution of this invention: a preparing method for making a single-crystal cathode material, wherein the method comprising:

Step 1, mixing and ball milling a lithium source with a nickel-cobalt-manganese polycrystalline precursor and then performing a first sinter-treating to obtain a first main material, wherein sinter temperature is 650 to 950°C and sinter time is 15- 30 hours;

Step 2, mixing and ball milling the first main material with source A and then performing a second sinter-treating to prepare a single-crystal cathode material, wherein sinter temperature is 650-950°C and sinter time is 5-15 hours.

In the above method, mass ratio of the first main material to the source A is 1.0: (0.002~0.01).

At same time, the present application further provides a single-crystal cathode material prepared by the above preparing method, and the chemical formula is $Li_aNi_xCo_yMn_zO_2 \cdot cA$, wherein $1 \leq a \leq 1.2$, $0 < c \leq 0.05$, $0 \leq x \leq 1$, $0 \leq y \leq 0.5$, $0 \leq z \leq 0.5$, and $x+y+z=1$, and the source A is a coating and selected from oxides or carbonates with large ionic radius.

Further, the oxides or carbonates with large ionic radius are one or more oxides or carbonates of Nb, Sr W and W.

Further, an average particle size of the single-crystal cathode material is 2-6$\mu$m.

Further, specific surface area of the single-crystal cathode material is 0.5-1.5m$^2$/g.

Further, total free lithium in the single-crystal cathode material is less than 1500ppm by mass.

The present application further provided a cathode plate, comprising a cathode current collector and cathode active substance, wherein the cathode active substance comprises the above single-crystal cathode materials.

The present application further provides a battery, comprising the above cathode plate.

The present application further provides an electrical device, wherein the electrical device includes the above battery and the battery is used to provide electrical energy.

Due to the above technical solution, the advantages of the present invention is as follows: the invention uses a polycrystalline precursor to directly make single-crystal cathode materials, and the synthesis of single-crystal cathode materials is achieved without the need for jet milling, making the process simple and cost-effective, and greatly enhancing the compatibility of the process.

## Brief Description of the Drawings

Figure 1 shows a SEM image of the precursor of the present invention.

Figure 2 shows a SEM image of the first main material of the present invention.

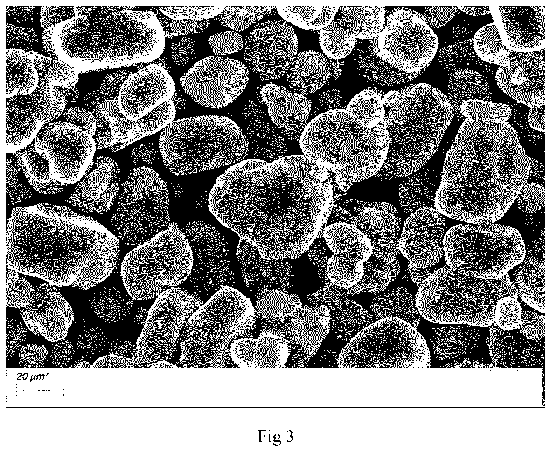

Figure 3 shows a SEM image of the single-crystal cathode material prepared by the method or the present invention.

## Detailed description of embodiments

For a better understanding of the technical solutions according to the embodiments of the present invention, further explanation and description will be provided below in conjunction with some preferred embodiments of the present application.

In this specification, quantities, ratios, and other numerical values are sometimes presented in a range format. It should be understood that such a range format is used for convenience and brevity, and should be flexibly understood, not only including the numerical values explicitly specified as the range limits, but also including all individual values or sub-ranges covered within the range herein, as if each value and sub-range were explicitly specified.

The chemical formula of the single-crystal cathode material of the present application is $Li_aNi_xCo_yMn_zO_2 \cdot cA$, wherein $1 \leq a \leq 1.2$, $0 < c \leq 0.05$, $0 \leq x \leq 1$, $0 \leq y \leq 0.5$, $0 \leq z \leq 0.5$, and $x+y+z=1$, and the source A is a coating source selected from one or more oxides or carbonates with large ionic radius. The oxides or carbonates with large ionic radius is one or more oxides or carbonates of Nb, Sr and W.

The single-crystal cathode material of the present application can be prepared using a conventional polycrystalline precursor without the jet milling method, greatly improving the compatibility of the process.

Compared with amorphous precursors, polycrystalline precursors have a higher yield, simpler process, and therefore relatively lower cost. Moreover, the process of this invention does not require jet milling, reducing the fine powders and eliminating the need for cyclone separation of fine powders, greatly optimizing the synthesis process of the single-crystal cathode material.

The coating source A is used for shallow coating. Due to its relatively large ionic radius, it tends to accumulate on the surface of primary particles, reducing the adhesion between particles. Under high temperature, it leads to the dispersion of primary particles, forming single-crystal cathode materials.

According to some embodiments, specific surface area of the above single-crystal cathode material can be 0.5-1.5 $m^2/g$, and the average particle size is 2-6 $\mu m$. the above single-crystal cathode material contains less than 1500 ppm of total free lithium by mass.

According to some embodiments of the present application, the above single-crystal cathode material can be used as a cathode material for lithium-ion batteries. For example, the above single-crystal cathode material, conductive carbon black (S.P), and binder polyvinylidene fluoride (PVDF) are added to N-methylpyrrolidone (NMP) (the weight ratio of the compound to NMP is 2.1:1) in a weight ratio of 94:3:3, and are fully mixed, stirred to form a uniform slurry to prepare the cathode material (or cathode active material), coated on an aluminum foil current collector, dried, and pressed to obtain a cathode plate, which can constitute an electrode assembly with the anode plate.

The present application further provides a battery, in particular to a lithium-ion battery, which comprises the above electrode assembly. This lithium-ion battery can be used in digital products, electric vehicles, or energy storage fields.

For example, a lithium-ion secondary battery is usually composed of electrode assembly, non-aqueous electrolyte, separator, and casing. In particular, the electrode assembly can include a cathode plate and an anode plate. As described above, the cathode plate comprises a cathode current collector and the cathode active material coated on the cathode current collector, as well as conventional binders, conventional conductive aids, and other materials. The cathode active material can comprise the above compound of the present application. The anode is made from a current collector and a conventional anode active material coated on the current collector, as well as conventional binders, conventional conductive aids, and other materials. The separator is a PP/PE film commonly used in this industry, and it is used to separate the cathode from the anode. The casing is the container for the cathode, anode, separator, and electrolyte.

When a 1 mol/L lithium hexafluorophosphate solution is used as the electrolyte, the solvent in the lithium hexafluorophosphate solution is a mixed solvent of dimethyl carbonate (DMC), ethylene carbonate (EC), and diethyl carbonate (DEC) in a mass ratio of 1:1:1, and when a mixture of artificial graphite, conductive carbon black, carboxymethyl cellulose, and binder in a weight ratio of 95:1:1:3 is used as anode material, the cathode plate is prepared with a mixture of the above compound, conductive carbon black, and PVDF in a weight ratio of 94:3:3, and then the battery cell is prepared, with the model number 454261, to ultimately form a battery.

The present application further provides an electrical device, including the above battery, wherein the battery is used to provide power. The electrical device can include digital products, electric vehicles, energy storage devices, etc. For example, it can be used for portable electronic devices and electric vehicles, and can also be used for energy storage power systems such as hydropower, thermal power, wind power, and solar power stations.

The present application provides a method for making single-crystal cathode material, comprising:

Step 1, mixing and ball milling a lithium source with a nickel-cobalt-manganese polycrystalline precursor and then performing a first sinter-treating to obtain a first main material, wherein sinter temperature is 650 to 950°C and sinter time is 15-30 hours;

Step 2, mixing and ball milling the first main material with source A and then performing a second sinter-treating to prepare a single-crystal cathode material, wherein the sinter temperature is 650-950°C and the sinter time is 5-15 hours.

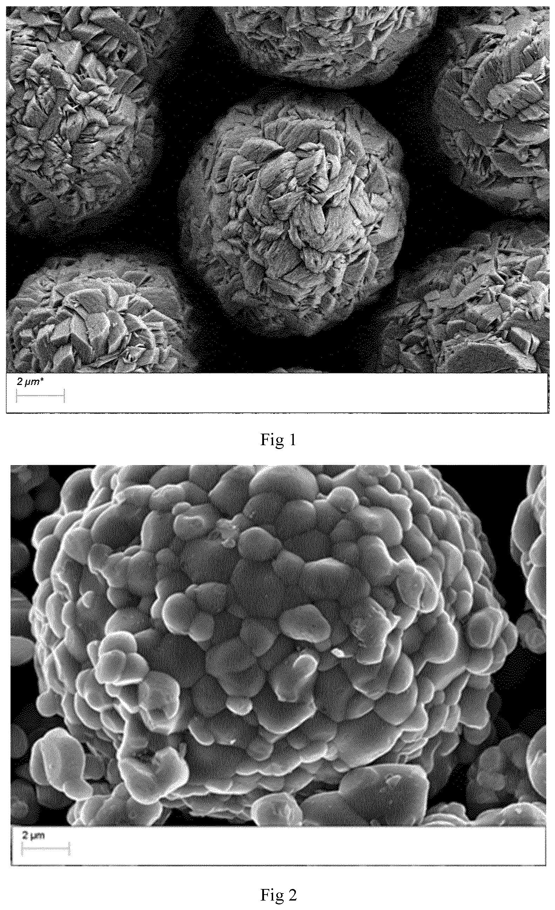

The morphology of the precursor is shown in Figure 1, which is a flaky structure composed of fine needle-like combinations. After mixing with the lithium source, the blocky structure of the cathode material formed by high-temperature sintering is shown in Figure 2. During this process, there is a process of fine needle-like structures merging and growing into a primary blocky structure. If the source A is added in Step 1, during sintering, it will penetrate into the crystal interior during the process of fine needle-like structures merging and growing into blocky structures, that is, it will enter the crystal structure interior during the crystal mergence and growth process, and will not be enriched on the surface of the primary blocky structure. When the source A is mixed and sintered in Step 2, due to the limitation of the crystal material channels, the large ionic radius of the A source cannot penetrate into the crystal interior and can only be enriched on the surface of the primary blocky structure, resulting in reduced adhesion between particles, the dispersion of primary particles, and the formation of single-crystal cathode materials. Conversely, if source A is added in Step 1, this effect will not be formed.

Compared with existing technologies, the preparing methods of the single-crystal cathode material provided by embodiments of the present application use a polycrystalline precursor and can synthesize single-crystal cathode materials without jet milling.

According to some embodiments of the present application, the lithium source can be selected from lithium hydroxide monohydrate or lithium carbonate.

According to some embodiments of the present application, the nickel-cobalt-manganese polycrystalline precursor is a hydroxide containing nickel, cobalt, and manganese elements, with a particle size of $8\mu m$-$20\mu m$.

According to some embodiments of the present application, the mass ratio of the first main material to source A is 1.0: (0.002-0.01), for example, 1: (0.003-0.007).

According to some embodiments of the present application, in the above methods, the first sintering temperature is 650-950°C, for example, 700-900°C, the first sintering time is 15-30 hours, for example, 20-24 hours, the second sintering temperature is 650-950°C, for example, 700-900°C, and the second sintering time is 5-15 hours, for example, 6-12 hours.

According to some embodiments of the present application, in the above methods, the first sintering temperature is 930°C, 900°C, 850°C, 780°C, or 720°C, and the first sintering time is 18 hours, 24 hours, or about 26 hours. The second sintering temperature is 900°C, 850°C, 820°C, 780°C, or 680°C, and the second sintering time is 6 hours, 8 hours, 12 hours, or 14 hours.

The following specific implementation examples illustrate the compound and preparing method and application thereof proposed according to the present application, and the reagents or instruments not recorded in this application text are content that can be conventionally confirmed by ordinary technicians in the field.

The reagents used in the following examples are shown in Table 1-1.

Tab 1-1 Information on the reagents used in the examples herein

| Reagent Name | Grade | Model | Manufacture r |
|---|---|---|---|
| Nickel-Cobalt-Manganese Precursor | Ni:Co:Mn= 1/3:1/3:1/3 | Particle size:$10\mu m$, Chemical formula: $Ni_{1/3}Co_{1/3}Mn_{1/3}(OH)_2$ | Guangdong Jana Energy Technology Co., Ltd |

(continued)

| Reagent Name | Grade | Model | Manufacturer |
|---|---|---|---|
| Nickel-Cobalt-Manganese Precursor | Ni:Co:Mn= 50:20:30 | Particle size:10$\mu$m, Chemical formula: $Ni_{0.5}Co_{0.2}Mn_{0.3}(OH)_2$ | Guangdong Jana Energy Technology Co., Ltd |
| Nickel-Cobalt-Manganese Precursor | Ni:Co:Mn= 60:10:30 | Particle size:10$\mu$m, Chemical formula: $Ni_{0.6}Co_{0.1}Mn_{0.3}(OH)_2$ | Guangdong Jana Energy Technology Co., Ltd |
| Nickel-Cobalt-Manganese Precursor | Ni:Co:Mn= 7:1:2 | Particle size:10$\mu$m, Chemical formula: $Ni_{0.7}Co_{0.1}Mn_{0.2}(OH)_2$ | Guangdong Jana Energy Technology Co., Ltd |
| Nickel-Cobalt-Manganese Precursor | Ni:Co:Mn= 83:07:10 | Particle size:10$\mu$m, Chemical formula: $Ni_{0.83}Co_{0.07}Mn_{0.10}(OH)_2$ | Guangdong Jana Energy Technology Co., Ltd |
| Nickel-Cobalt-Manganese Precursor | Ni:Co:Mn= 92:5:3 | Particle size:10$\mu$m, Chemical formula: $Ni_{0.92}Co_{0.05}Mn_{0.03}(OH)_2$ | Guangdong Jana Energy Technology Co., Ltd |
| Nickel-Cobalt-Manganese Precursor | Ni:Co:Mn= 97:2:1 | Particle size:10$\mu$m, Chemical formula: $Ni_{0.97}Co_{0.02}Mn_{0.01}(OH)_2$ | Guangdong Jana Energy Technology Co., Ltd |
| Nano niobium oxide | Ceramic Grade | --- | Anhui Xuancheng Jingrui New Material Co., Ltd. |
| Nano tantalum oxide | Ceramic Grade | --- | Anhui Xuancheng Jingrui New Material Co., Ltd. |
| Nano molybdenum oxide | Ceramic Grade | --- | Anhui Xuancheng Jingrui New Material Co., Ltd. |
| Nano tungsten oxide | Ceramic Grade | --- | Anhui Xuancheng Jingrui New Material Co., Ltd. |
| Lithium hydroxide monohydrate | Battery Grade | 99.5wt% | Jiangxi Ganfeng Lithium Co., Ltd. |
| Lithium Carbonate | Battery Grade | 99.5wt% | Jiangxi Ganfeng Lithium Co., Ltd |
| Methyl Red | Chemical Pure | 99.5wt% | Tianjin Guangfu Technology Development Co., Ltd. |

(continued)

| Reagent Name | Grade | Model | Manufacture r |
|---|---|---|---|
| Phenolphthalein | Chemical Pure | 99.9wt% | Chengdu Jinshan Chemical Reagent Co., Ltd. |
| HCL | Chemical Pure | 99.9wt% | Sichuan Xiluong Science Co., Ltd. |
| High Purity Oxygen | Industrial Grade | Purity99.95% | Shenzhen Nanshan Gas Station |
| Conductive carbon black | Battery Grade | Super P Li | Schunk Carbon Technology AG, Switzerland |
| N-Methyl-2-Pyrrolidone | Battery Grade | 99.5%content | Jiangsu Nanjing Jinlong Chemical Factory |
| Polyvinylidene Fluoride | Battery Grade | Solef 6020 | Solvay Chemicals, USA |
| Aluminum Foil | Battery Grade | Thickness16μm | Alcoa Inc., USA |
| Electronic Tape | Electronic Grade | Green, Width10mm | 3M Company, USA |
| Lithium Foil | Electronic Grade | DiameterΦ20mm, Purity≥99.9% | Shanghai Shunyou Metal Material Co., Ltd. |
| Electrolyte | Electronic Grade | Mixture solvent: Dimethyl Carbonate (DMC): Ethylene Carbonate (EC): Diethyl Carbonate (DEC) = 1:1:1 (mass ratio), Electrolyte: Lithium Hexafluorophosp hate; Concentration of Lithium Hexafluorophosp hate in the electrolyte is 1 mol/L | Shenzhen Xinzebon Company |
| Separator | --- | PP/PE/PP three-layer material, Celgard M825, Thickness 16μm | Celgard, LLC, USA |
| Aluminum Plastic Film | Industrial Grade | Total Thickness 160μm | Dai Nippon Printing Co., Ltd. (DNP), Japan |

The equipment and analytical methods used in the following examples are as follows:

The mixing and ball milling equipment is the SHQM model dual planetary ball mill from Lianyungang Chunlong Experimental Instrument Co., Ltd.

The present application uses a fully automatic specific surface area and porosity analyzer (TriStar II 3020 from Micromeritics Instrument Corp., USA) to test and analyze the specific surface area.

The test method for free lithium in the compound is as follows:

Accurately weigh an appropriate amount of the sample in m grams (about 30g), accurate to 0.01g; put the sample into a 250mL conical flask, place a magnetic stirring bar, and add 100mL of deionized water; place the conical flask on a magnetic stirrer and stir for 30 minutes; filter the mixture through filter paper and a funnel; use a 50mL pipette to transfer 50mL of the filtrate into a 100mL beaker, and stir using a magnetic stirring bar; place the beaker on a magnetic stirrer, and add 2 drops of phenolphthalein indicator; titrate with a 0.05mol/L hydrochloric acid standard titration solution until the solution changes from red to colorless; record the volume V1 (end point 1) of the 0.05mol/L hydrochloric acid standard titration solution; add 2 drops of methyl red indicator and the color changes from colorless to yellow; titrate with a 0.05mol/L hydrochloric acid standard titration solution until the solution changes from yellow to orange; heat the beaker on a hot plate until the solution boils (the color changes from orange to yellow); remove the 100mL beaker and cool down to room temperature; place the beaker on a magnetic stirrer again; titrate with a 0.05mol/L hydrochloric acid standard titration solution until the color changes from yellow to light red and record the volume V2 (end point 2); Lithium hydroxide:

LiOH(wt%) = [V2 - 2 × (V2 - V1)] × 0.05 × 23.946 × 2 × 100 / (m × 1000); Lithium carbonate: $Li_2CO_3$(wt%) = (V2 - V1) × 0.05 × 73.886 × 2 × 100 / (m×1000);

$$\text{Free lithium: } Li+(wt\%) = V2 \times 0.05 \times 6.94 \times 2 \times 100 / (m \times 1000).$$

The test for average particle size: The MS3000 laser particle size analyzer is used for testing, the method is as follows:
Take an appropriate amount of the sample into a 100mL beaker, firstly rinse around the inner wall of the beaker with a wash bottle, then rinse the sample stuck at the bottom of the beaker with a wash bottle, and control the amount of pure water added to the beaker to 20-30mL, wherein ultrasonic time is 5min (stir for 10s before, during, and after ultrasonication, and stirring speed is about 2r/s). Add 100 ± 10mL of pure water to the sampler of the MS3000 laser particle size analyzer, adjust the speed to 3000r/min, click start, the instrument automatically aligns, measure the background and wait for the prompt to operate. After ultrasonication, transfer the sample to the stirring trough, and rinse the beaker with a wash bottle to ensure all the sample is transferred. After the sample is completely added, the software automatically starts measuring. After the measurement is completed, the data is automatically saved.

The preparing method for making the battery (the battery cell model is 454261) using the compound of the present application is as follows:
Cathode plate preparation: add the compound proposed by the present application, conductive carbon black (S.P), binder polyvinylidene fluoride (PVDF) in a weight ratio of 94:3:3 into N-methylpyrrolidone (NMP) (the weight ratio of the compound herein to NMP is 2.1:1) for thorough mixing, and stir to form a uniform slurry, coat on an aluminum foil current collector, dry and press into a cathode plate.

Anode plate preparation: add the anode artificial graphite, conductive carbon black (S.P), carboxymethyl cellulose (CMC), and binder (SBR) in a weight ratio of 95:1:1:3 into sufficient pure water, stir to form uniform slurry, coat it on a copper foil current collector, dry and press to form an anode plate.

The separator is a PP/PE/PP three-layer composite film material.

Spot weld the pressed cathode and anode plate with ears, insert the separator, roll on a winding machine, and then put it into a soft package fixture for top and side sealing, then put it into an oven for baking. After that, inject 9g of electrolyte in an environment with a relative humidity of less than 1.5%, after 48 hours of formation (Zhejiang Hangke LIP-3AHB06 high-temperature formation system), and vacuum seal it.

Sample drying and high-temperature battery testing use Dongguan Coreay Machinery KPBAK-03E-02 high-efficiency vacuum drying oven.

The charge and discharge test of the lithium-ion secondary battery of the present application is carried out according to the test method of GB/T18287-2000, tested on Wuhan Blue Electric Battery Tester (Wuhan Blue Electric CT2001C test equipment). Due to different battery systems, the impact on the cycle retention rate of materials is large. The battery system used in the experiment is the most common evaluation system, that is, a solution of 1 mol/L lithium hexafluorophosphate is used as the electrolyte, the solvent in the lithium hexafluorophosphate solution is a mixed solvent of dimethyl carbonate (DMC): ethylene carbonate (EC): diethyl carbonate (DEC) = 1:1:1 (mass ratio), and the anode material is a mixture of artificial graphite, conductive carbon black, carboxymethyl cellulose, and binder in a weight ratio of 95:1:1:3. The battery cell model is 454261, so as to expose the actual defects of the cathode material as soon as possible and determine the performance of the cathode material.

**Example 1**

Add lithium hydroxide monohydrate and a precursor with a molar ratio of Ni: Co: Mn=1/3: 1/3: 1/3 (the chemical formula: $Ni_{1/3}Co_{1/3}Mn_{1/3}(OH)_2$), in a molar ratio of Li: (Ni+Co+Mn)=1.08:1 and ball mill at a rotation speed of 40Hz for 10 minutes to ensure uniform mixing, then the material (i.e., the mixed material) is discharged. The mixed material is placed in a muffle furnace, sintered for 18 hours at 930°C under an oxygen atmosphere with a heating rate of 5°C/min, and cooled down to room temperature. After that, it is ball milled for another 10 minutes at a rotation speed of 40Hz to obtain the first main material. Then, according to the mass ratio of the first main material to tungsten oxide of 1.0:0.004, the appropriate amount of tungsten oxide is weighed and added to the first main material for ball milling at a rotation speed of 40Hz for 10 minutes. The uniformly mixed material is placed in a muffle furnace, sintered at 900°C under an oxygen atmosphere with a heating rate of 10°C/min for 8 hours, cooled down to room temperature, and ball-milled for another 10 minutes at a rotation speed of 40Hz. The material is then sieved using a 300-mesh metal screen to obtain the single-crystal cathode material 1.

The particle size, specific surface area, free lithium content, and battery testing of the single-crystal cathode material 1 are conducted, and the data can be found in Table 1.

**Example 2**

Add lithium hydroxide monohydrate and a precursor with a molar ratio of Ni: Co: Mn=5: 2: 3 (the chemical formula: $Ni_{0.5}Co_{0.2}Mn_{0.3}(OH)_2$), in a molar ratio of Li: (Ni+Co+Mn)=1.06:1 and ball mill at a rotation speed of 40Hz for 10 minutes to ensure uniform mixing, then the material (i.e., the mixed material) is discharged. The mixed material is placed in a muffle furnace, sintered for 24 hours at 900°C under an oxygen atmosphere with a heating rate of 5°C/min, and cooled down to room temperature. After that, it is ball milled for another 10 minutes at a rotation speed of 40Hz to obtain the first main material. Then, according to the mass ratio of the first main material to niobium oxide of 1.0:0.005, the appropriate amount of niobium oxide is weighed and added to the first main material for ball milling at a rotation speed of 40Hz for 10 minutes. The uniformly mixed material is placed in a muffle furnace, sintered at 900°C under an oxygen atmosphere with a heating rate of 10°C/min for 6 hours, cooled down to room temperature, and ball-milled for another 10 minutes at a rotation speed of 40Hz. The material is then sieved using a 300-mesh metal screen to obtain the single-crystal cathode material 2.

The particle size, specific surface area, free lithium content, and battery testing of the single-crystal cathode material 2 are conducted, and the data can be found in Table 1.

**Example 3**

Add lithium hydroxide monohydrate and a precursor with a molar ratio of Ni: Co: Mn=6: 1: 3 (the chemical formula: $Ni_{0.6}Co_{0.1}Mn_{0.3}(OH)_2$), in a molar ratio of Li: (Ni+Co+Mn)=1.10:1 and ball mill at a rotation speed of 40Hz for 10 minutes to ensure uniform mixing, then the material (i.e., the mixed material) is discharged. The mixed material is placed in a muffle furnace, sintered for 24 hours at 900°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to tungsten oxide of 1.0:0.006, the appropriate amount of tungsten oxide is weighed and added to the first main material for ball milling at a rotation speed of 40Hz for 10 minutes. The uniformly mixed material is placed in a muffle furnace, sintered at 850°C under an oxygen atmosphere with a heating rate of 10°C/min for 12 hours, cooled down to room temperature, and ball milled for another 10 minutes at a rotation speed of 40Hz. The material is then sieved using a 300-mesh metal screen to obtain the single-crystal cathode material 3.

The particle size, specific surface area, free lithium content, and battery testing of the single-crystal cathode material 3 are conducted, and the data can be found in Table 1.

**Example 4**

Add lithium hydroxide monohydrate and a precursor with a molar ratio of Ni: Co: Mn=7: 1: 2 (the chemical formula: $Ni_{0.7}Co_{0.1}Mn_{0.2}(OH)_2$), in a molar ratio of Li: (Ni+Co+Mn)=1.12:1 and ball mill at a rotation speed of 40Hz for 10 minutes to ensure uniform mixing, then the material is discharged (i.e., the mixed material is obtained). The mixed material is placed in a muffle furnace, sintered for 24 hours at 850°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to strontium carbonate of 1.0:0.004, the appropriate amount of strontium carbonate is weighed and added to the first main material for ball milling at a rotation speed of 40Hz for 10 minutes. The uniformly mixed material is placed in a muffle furnace, sintered at 820°C under an oxygen atmosphere with a heating rate of 10°C/min for 14 hours, cooled down to room temperature, and ball-milled for another 10 minutes at a rotation speed of 40Hz. The material is then sieved using a 300-mesh metal screen to obtain the single-crystal cathode material 4.

The particle size, specific surface area, free lithium content, and battery testing of the single-crystal cathode material 4 are conducted, and the data can be found in Table 1.

**Example 5**

Add lithium hydroxide monohydrate and a precursor with a molar ratio of Ni: Co: Mn=83: 07: 10 (the chemical formula: $Ni_{0.83}Co_{0.07}Mn_{0.10}(OH)_2$), in a molar ratio of Li: (Ni+Co+Mn)=1.08:1 and ball mill at a rotation speed of 40Hz for 10 minutes to ensure uniform mixing, then the material (i.e., the mixed material is obtained) is discharged. The mixed material is placed in a muffle furnace, sintered for 26 hours at 780°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to tungsten oxide of 1.0:0.006, the appropriate amount of tungsten oxide is weighed and added to the first main material for ball-milling at a rotation speed of 40Hz for 10 minutes. The uniformly mixed material is placed in a muffle furnace, sintered at 780°C under an oxygen atmosphere with a heating rate of 10°C/min for 8 hours, cooled down to room temperature, and ball-milled for another 10 minutes at a rotation speed of 40Hz. The material is then sieved using a 300-mesh metal screen to obtain the single-crystal cathode material 5.

The particle size, specific surface area, free lithium content, and battery testing of the single-crystal cathode material 5 are conducted, and the data can be found in Table 1.

**Example 6**

Add lithium hydroxide monohydrate and a precursor with a molar ratio of Ni: Co: Mn=92: 05: 03(the chemical formula: $Ni_{0.92}Co_{0.05}Mn_{0.03}(OH)_2$), in a molar ratio of Li: (Ni+Co+Mn)=1.16:1 and ball mill at a rotation speed of 40Hz for 10 minutes to ensure uniform mixing, then the material (i.e., the mixed material) is discharged. The mixed material is placed in a muffle furnace, sintered for 24 hours at 720°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to tungsten oxide of 1.0:0.004, the appropriate amount of tungsten oxide is weighed and added to the first main material for ball-milling at a rotation speed of 40Hz for 10 minutes. The uniformly mixed material is placed in a muffle furnace, sintered at 680°C under an oxygen atmosphere with a heating rate of 10°C/min for 8 hours, cooled down to room temperature, and ball-milled for another 10 minutes at a rotation speed of 40Hz. The material is then sieved using a 300-mesh metal screen to obtain the single-crystal cathode material 6.

The particle size, specific surface area, free lithium content, and battery testing of the single-crystal cathode material 6 are conducted, and the data can be found in Table 1.

**Example 7**

Add lithium hydroxide monohydrate and a precursor with a molar ratio of Ni: Co: Mn=97: 02: 01 (the chemical formula: $Ni_{0.97}Co_{0.02}Mn_{0.01}(OH)_2$), in a molar ratio of Li: (Ni+Co+Mn)=1.08:1 and ball mill at a rotation speed of 40Hz for 10 minutes to ensure uniform mixing, then the material (i.e., the mixed material) is discharged. The mixed material is placed in a muffle furnace, sintered for 30 hours at 650°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to tungsten oxide of 1.0:0.004, the appropriate amount of tungsten oxide is weighed and added to the first main material for ball-milling at a rotation speed of 40Hz for 10 minutes. The uniformly mixed material is placed in a muffle furnace, sintered at 650°C under an oxygen atmosphere with a heating rate of 10°C/min for 15 hours, cooled down to room temperature, and ball-milled for another 10 minutes at a rotation speed of 40Hz. The material is then sieved using a 300-mesh metal screen to obtain the single-crystal cathode material 7.

The particle size, specific surface area, free lithium content, and battery testing of the single-crystal cathode material 7 are conducted, and the data can be found in Table 1.

**Example 8**

Add lithium hydroxide monohydrate and a precursor with a molar ratio of Ni: Co: Mn=1/3: 1/3: 1/3 (the chemical formula:$Ni_{1/3}Co_{1/3}Mn_{1/3}(OH)_2$), in a molar ratio of Li: (Ni+Co+Mn)=1.06:1 and ball mill at a rotation speed of 40Hz for 10 minutes to ensure uniform mixing, then the material (i.e., the mixed material) is discharged. The mixed material is placed in a muffle furnace, sintered for 15 hours at 950°C under an oxygen atmosphere with a heating rate of 5°C/min, and cooled down to room temperature. After that, it is ball-milled for another 10 minutes at a rotation speed of 40Hz to obtain the first main material. Then, according to the mass ratio of the first main material to tungsten oxide of 1.0:0.004, the appropriate amount of tungsten oxide is weighed and added to the first main material for ball-milling at a rotation speed of 40Hz for 10 minutes. The uniformly mixed material is placed in a muffle furnace, sintered at 950°C under an oxygen atmosphere with a heating rate of 10°C/min for 5 hours, cooled down to room temperature, and ball-milled for another 10 minutes at a rotation speed of 40Hz. The material is then sieved using a 300-mesh metal screen to obtain the single-crystal cathode material 8.

The particle size, specific surface area, free lithium content, and battery testing of the single-crystal cathode material 8 are conducted, and the data can be found in Table 1.

**Comparative Example 1**

Add lithium hydroxide monohydrate and an amorphous precursor precursor with a molar ratio of Ni: Co: Mn=83: 07: 10, in a molar ratio of Li: (Ni+Co+Mn)=1.12:1 and ball mill at a rotation speed of 40Hz for 10 minutes to ensure uniform mixing, then the material (i.e., the mixed material) is discharged. The mixed material is placed in a muffle furnace, sintered for 20 hours at 800°C under an oxygen atmosphere with a heating rate of 5°C/min, and cooled down to room temperature. The mixed material is then sieved using a 300-mesh metal screen to obtain the comparative single-crystal cathode material D1.

The particle size, specific surface area, free lithium content, and battery testing of the comparative single-crystal cathode material D1 are conducted, and the data can be found in Table 1.

**Comparative Example 2**

Add lithium hydroxide monohydrate and a precursor with a molar ratio of Ni: Co: Mn=83: 07: 10 (the chemical formula: $Ni_{0.83}Co_{0.07}Mn_{0.1}(OH)_2$), in a molar ratio of Li: (Ni+Co+Mn)=1.10:1 and ball mill at a rotation speed of 40Hz for 10 minutes to ensure uniform mixing, then the material (i.e., the mixed material) is discharged. The mixed material is placed in a muffle furnace, sintered for 28 hours at 830°C under an oxygen atmosphere with a heating rate of 5°C/min, and cooled down to room temperature. The mixed material is jet milled and then sieved using a 300-mesh metal screen to obtain the comparative single-crystal cathode material D2.

The particle size, specific surface area, free lithium content, and battery testing of the comparative single-crystal cathode material D2 are conducted, and the data can be found in Table 1.

Tab 1 Characterization Data of Compounds Obtained from Examples

| Single-crystal cathode materia l | Specific Surface Area ( $m^2$/g) | Particle Size | Free Lithium | Capacity | Capacity Retention (%) |
|---|---|---|---|---|---|
| | | D50 ($\mu$m) | Total Free Lithium (ppm) | 4.2V 1C ( mAh/g) | 4.3V 45°C@300times |
| 1 | 0.54 | 4.25 | 140 | 148 | 97 |
| 2 | 0.65 | 3.78 | 220 | 158 | 97 |
| 3 | 0.68 | 4.16 | 320 | 163 | 95 |
| 4 | 0.74 | 3.88 | 580 | 175 | 93 |
| 5 | 0.82 | 3.29 | 780 | 191 | 90 |
| 6 | 0.97 | 3.43 | 970 | 195 | 84 |
| 7 | 1.02 | 3.34 | 1025 | 197 | 83 |
| 8 | 0.52 | 4.36 | 129 | 147 | 97 |
| D1 | 0.95 | 2.98 | 1210 | 188 | 89 |
| D2 | 1.12 | 2.78 | 1432 | 185 | 78 |

As shown in Table 1, the single-crystal cathode material made according to the examples described above has a total free lithium content of less than 1500 ppm, a specific surface area between 0.5 and 1.5 $m^2$/g, and a particle size between 2.0 and 6.0 $\mu$m, a single-crystal morphology of primary particles.

From Table 1, it can be observed that in the examples implemented, the method of the present application can achieve the synthesis of single-crystal cathode materials. Compared to the two current methods for synthesizing single-crystal cathode materials, the present application is not dependent on the precursor. Any precursor can achieve single crystal, and there is no need for jet milling. This effectively avoids the damage to primary particles caused by air flow, thereby enhancing the stability of the material.

**Claims**

1. A preparing method for making a single-crystal cathode material, wherein the method comprising:

    Step 1, mixing and ball milling a lithium source with a nickel-cobalt-manganese polycrystalline precursor and then performing a first sinter-treating to obtain a first main material, wherein sinter temperature is 650 to 950°C and sinter time is 15- 30 hours;

Step 2, mixing and ball milling the first main material with source A and then performing a second sinter-treating to prepare a single-crystal cathode material, wherein sinter temperature is 650-950°C and sinter time is 5-15 hours, and the source A is a coating and selected from oxides or carbonates with large ionic radius, and the oxides or carbonates with large ionic radius are one or more oxides or carbonates of Nb, Sr and W; chemical formula of the single-crystal cathode material is $Li_aNi_xCo_yMn_zO_2 \cdot cA$, wherein $1 \leq a \leq 1.2$, $0 < c \leq 0.05$, $0 \leq x \leq 1$, $0 \leq y \leq 0.5$, $0 \leq z \leq 0.5$, and $x+y+z=1$.

2. The preparing method for making a single-crystal cathode material of claim 1, wherein mass ratio of the first main material to the source A is 1.0: (0.002-0.01).

3. A single-crystal cathode material, wherein the single-crystal cathode material is obtained by the method of claims 1 or 2.

4. The single-crystal cathode material of claim 3, wherein an average particle size of the single-crystal cathode material is $2\text{-}6\mu m$.

5. The single-crystal cathode material of claim 3, wherein specific surface area of the single-crystal cathode material is $0.5\text{-}1.5m^2/g$.

6. The single-crystal cathode material of claim 3, wherein total free lithium in the single-crystal cathode material is less than 1500ppm by mass.

7. A cathode plate, comprising a cathode current collector and cathode active substance, wherein the cathode active substance comprises the single-crystal cathode materials of any one of claims 3 to 6.

8. A battery, wherein the battery comprises the cathode plate of claim 7.

9. An electrical device, wherein the electrical device includes the battery of claim 8 and the battery is used to provide electrical energy.

EP 4 678 601 A1

Fig 1

Fig 2

20 μm*

Fig 3

Europäisches
Patentamt
European
Patent Office
Office européen
des brevets

# EUROPEAN SEARCH REPORT

**Application Number**

EP 25 18 1242

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 960 337 A (HEADING GUOLIAN SICHUAN CELL MAT CO LTD) 27 October 2023 (2023-10-27) * examples * ----- | 1-9 | INV. C01G53/42 C01G53/504 C01G53/506 H01M4/00 |
| X | CN 118 073 560 A (SHENZHEN BTR NANOMETER TECH CO LTD) 24 May 2024 (2024-05-24) * examples 5,6 * ----- | 1-9 | |
| X | CN 116 053 446 A (BASF SHANSHAN BATTERY MAT CO LTD) 2 May 2023 (2023-05-02) * examples * ----- | 1-9 | |
| X | CN 115 477 333 A (TIANJIN BAMO TECH CO LTD) 16 December 2022 (2022-12-16) * examples * ----- | 3-9 | |
| X | EP 3 751 646 A1 (LG CHEMICAL LTD [KR]) 16 December 2020 (2020-12-16) * examples * ----- | 1-9 | |

**TECHNICAL FIELDS SEARCHED (IPC)**

C01G
H01M

The present search report has been drawn up for all claims

| Place of search | Date of completion of the search | Examiner |
|---|---|---|
| Munich | 4 December 2025 | Doslik, Natasa |

EPO FORM 1503 03.82 (P04C01)

14

## ANNEX TO THE EUROPEAN SEARCH REPORT
## ON EUROPEAN PATENT APPLICATION NO.

**EP 25 18 1242**

This annex lists the patent family members relating to the patent documents cited in the above-mentioned European search report.
The members are as contained in the European Patent Office EDP file on
The European Patent Office is in no way liable for these particulars which are merely given for the purpose of information.

**04-12-2025**

| Patent document cited in search report | | Publication date | Patent family member(s) | | Publication date |
|---|---|---|---|---|---|
| CN 116960337 | A | 27-10-2023 | NONE | | |
| CN 118073560 | A | 24-05-2024 | CN | 117476924 A | 30-01-2024 |
| | | | CN | 118073560 A | 24-05-2024 |
| | | | KR | 20250130695 A | 02-09-2025 |
| | | | WO | 2025077850 A1 | 17-04-2025 |
| CN 116053446 | A | 02-05-2023 | CN | 116053446 A | 02-05-2023 |
| | | | WO | 2024183609 A1 | 12-09-2024 |
| CN 115477333 | A | 16-12-2022 | NONE | | |
| EP 3751646 | A1 | 16-12-2020 | CN | 111819718 A | 23-10-2020 |
| | | | CN | 118099413 A | 28-05-2024 |
| | | | EP | 3751646 A1 | 16-12-2020 |
| | | | EP | 4339164 A2 | 20-03-2024 |
| | | | ES | 2980221 T3 | 30-09-2024 |
| | | | HU | E066540 T2 | 28-08-2024 |
| | | | JP | 7139008 B2 | 20-09-2022 |
| | | | JP | 2021516424 A | 01-07-2021 |
| | | | KR | 20190131842 A | 27-11-2019 |
| | | | KR | 20220132491 A | 30-09-2022 |
| | | | PL | 3751646 T3 | 15-07-2024 |
| | | | US | 2021135187 A1 | 06-05-2021 |
| | | | US | 2024258499 A1 | 01-08-2024 |
| | | | WO | 2019221497 A1 | 21-11-2019 |

EPO FORM P0459

For more details about this annex : see Official Journal of the European Patent Office, No. 12/82